# EUROPÄISCHE PATENTANMELDUNG

(11) **EP 2 110 676 A2**
(43) Veröffentlichungstag der Anmeldung: **21.10.2009**
(21) Anmeldenummer: 09154828.9
(22) Anmeldetag: 11.03.2009
(51) Int. Cl.: G01R 19/25, G01R 31/00

(54) **Verfahren zum Ermitteln eines Nutzsignals**

(30) Priorität: 16.04.2008 DE 102008001202
(71) Anmelder: ZF Friedrichshafen AG, 88038 Friedrichshafen (DE)
(72) Erfinder: Bitzer, Franz, 88048, Friedrichshafen (DE)

(57) **Zusammenfassung**

Die Erfindung betrifft ein Verfahren zum Ermitteln eines Nutzsignals (N) aus einem von wenigstens einem Störsignal (Σᵥ) überlagerten Messsignal (M) zur Verwendung in einem Steuer- bzw. Regelgerät, beispielsweise eines Fahrzeugs oder dergleichen, wobei das Störsignal (Σᵥ) mit wenigstens einer bekannten Störsignalfrequenz (v) auftritt. Die Erfindung ist gekennzeichnet durch: ein in einem ersten Schritt (S₁) erfolgendes Ermitteln des Messsignals (M), ein in einem zweiten Schritt (S₂) bezüglich der bekannten Störsignalfrequenz (v) erfolgendes Vornehmen einer Fouriertransformation (Fᵥ(M)) an dem Messsignal (M) zur Ermittlung der Störsignalamplitude (A_{Σ}) und der Störsignalphase (ϕ_{Σ}), ein in einem dritten Schritt (S₃) erfolgendes Ermitteln des Störsignals (Σᵥ) auf der Grundlage der Störsignalamplitude (A_{Σ}) und der Störsignalphase (ϕ_{Σ}), und ein in einem vierten Schritt (S₄) erfolgendes Entfernen des Störsignals (Σᵥ) aus dem Messsignal (M) zur Ermittlung des Nutzsignals (N). Erfindungsgemäß wird die Fouriertransformation (Fᵥ(M)) in dem zweiten Schritt (S₂) lediglich bezüglich der bekannten Störsignalfrequenz (v) vorgenommen. Hierdurch wird der rechentechnische Aufwand zur Ermittlung des Nutzsignals (N) aus dem Messsignal (M) in dem Steuer- bzw. Regelgerät des Fahrzeugs gering gehalten, weshalb das Nutzsignal (N) in Echtzeit ermittelt werden kann.

## Beschreibung

Die Erfindung betrifft ein Verfahren zum Ermitteln eines Nutzsignals aus einem von wenigstens einem Störsignal überlagerten Messsignal zur Verwendung in einem Steuer- bzw. Regelgerät, beispielsweise eines Fahrzeugs oder dergleichen, wobei das Störsignal mit wenigstens einer bekannten Störsignalfrequenz auftritt.

Messsignale zum Erfassen von Kenngrößen technischer Geräte sind für eine Analyse der Kenngrößen und eine hierauf beruhende Steuerung oder Regelung der Kenngrößen auf vielen Gebieten der Technik das Mittel schlechthin. Die Messsignale liegen zumeist in elektronischer Form, so beispielsweise als elektrische Spannungen, vor.

Ein Gebiet der Technik, in dem Messsignale eine bedeutende Rolle spielen, ist die Fahrzeugtechnik. Dort werden sie verwendet, um Kenngrößen verschiedener Komponenten des Fahrzeugs, so beispielsweise Kenngrößen des Antriebsmotors, der Kupplung oder des Getriebes, zu erfassen und diese zu analysieren, damit eine Steuerung oder Regelung der Kenngrößen bzw. der Fahrzeugkomponenten erfolgen kann. Die Kenngrößen können dabei nicht periodischer oder periodischer Natur sein. Zu den Beispielen für nicht periodische Kenngrößen zählen in der Fahrzeugtechnik unter anderem die Geschwindigkeit des Fahrzeugs, während zu den periodischen Kenngrößen die Drehwinkelstellung der Eingangswelle des Fahrzeuggetriebes gehört.

Hierbei tritt oftmals der Fall auf, dass das Messsignal nicht die zu analysierende Kenngröße allein, sondern auch mit dieser Kenngröße in Zusammenhang stehende andere Kenngrößen erfasst. Das Messsignal entspricht in diesem Fall nicht dem für die Analyse der Kenngröße notwendigen, reinen Nutzsignal, sondern ist von einem Störsignal überlagert. Die Störsignale in den Messsignalen erreichen nicht selten eine Größenordnung, welche die Analyse der Kenngröße derart erschwert oder verfälscht, dass die auf der Analyse beruhende Steuerung oder Regelung der dem Messsignal zugrunde liegenden Kenngröße nicht mehr adäquat möglich ist.

In einem in der Fahrzeugtechnik sehr häufig auftretenden Fall tritt die Ursache eines Störsignals periodisch auf, wobei die Periode der Ursache bekannt ist. Das Störsignal ist dann ebenfalls periodisch, wobei die Periode des Störsignals zumeist mittels einer Störsignalfrequenz beschrieben wird. Kennt man die Ursache eines Störsignals, so ist zumeist auch die Störsignalfrequenz bekannt. Ein Beispiel hierfür ist die bei Triebsträngen mit bekannter Periode auftretende Triebstrangeigenschwingung, die ein Störsignal verursacht, das sich mit bekannter Störsignalfrequenz dem Messsignal der Eingangsdrehzahl des Getriebes eines Fahrzeuges überlagert.

Es besteht demnach die Notwendigkeit, Verfahren und zugehörige Vorrichtungen zu entwickeln, mittels derer Störsignale aus einem Messsignal entfernt werden können, um das Nutzsignal zu ermitteln.

Aus dem Stand der Technik sind verschiedene zu diesem Zweck entwickelte Verfahren und zugehörige Vorrichtungen bekannt.

Eine Art von weit verbreiteten Verfahren verwendet Filteralgorithmen, die auf Hochpass-, Tiefpass-, Bandpass- oder Bandsperrfiltern beruhen. Derartige Filteralgorithmen weisen jedoch zahlreiche Nachteile auf. So kann in Abhängigkeit von der jeweiligen Filterfrequenz oder Eckfrequenz ein Phasenverzug auftreten, der sich bei der Steuerung oder Regelung einer Kenngröße nachteilig auswirkt. Zudem müssen die Filterparameter derart gewählt werden, dass sie an eine bestimmte Filterfrequenz optimal angepasst sind. Ändert sich die Filterfrequenz, so müssen auch die Filterparameter geändert werden, um die optimale Anpassung aufrechtzuerhalten. Man begegnet dem häufig durch Implementieren mehrerer Filter mit verschiedenen Filterfrequenzen, was jedoch bautechnisch sehr aufwendig ist. Sind bei den Filtern Kennkurven mit steilen Flanken von Nöten, so steigt darüber hinaus die Filterordnung und damit die Anzahl der Filterparameter, was ebenfalls den softwaretechnischen und/oder bautechnischen Aufwand für die Filter erhöht.

Eine andere Art von ebenfalls häufig Verwendung findenden Verfahren beruht auf Integraltransformationen. Die deutsche Gebrauchsmusterschrift DE 20 2004 009 922 U1 zeigt einige einschlägige Integraltransformationen aus der Klasse der Wavelet-Transformationen. Wavelet-Transformationen sind rechentechnisch sehr aufwendig und können aufgrund der begrenzten Rechenleistung der Steuer- bzw. Regelgerät von Kraftfahrzeugen üblicherweise nicht verwendet werden, um Kenngrößen in Echtzeit zu steuern oder zu regeln.

Eine weitere Art von praxisrelevanten Verfahren beruht auf einer anderen Art von Integraltransformation, nämlich der Fouriertransformation, die ebenfalls in der deutschen Gebrauchsmusterschrift DE 20 2004 009 922 U1 erwähnt ist. Von Nachteil bei Fouriertransformationen ist, dass sie zumeist bezüglich einer Vielzahl von Frequenzen vorgenommen werden. Der rechentechnische Aufwand ist dabei ebenfalls oftmals derart hoch, dass in den Steuer- bzw. Regelgerät von Kraftfahrzeugen keine Analyse des Messsignals in Echtzeit und damit auch keine Steuerung oder Regelung der dem Messsignal zugrunde liegenden Kenngröße erfolgen kann.

Der Erfindung liegt daher die Aufgabe zugrunde, ein Verfahren der hier in Rede stehenden Art bereitzustellen, bei dem sich der rechentechnische Aufwand beim Ermitteln eines Nutzsignals aus einem von wenigstens einem Störsignal überlagerten Messsignal gering hält, damit das Nutzsignal in Echtzeit vom Steuer- bzw. Regelgerät, beispielsweise in einem Fahrzeug, ermittelt werden kann.

Gelöst wird diese Aufgabe von einem Verfahren zum Ermitteln eines Nutzsignals aus einem von wenigstens einem Störsignal überlagerten Messsignal zur Verwendung in einem Steuer- bzw. Regelgerät, beispielsweise eines Fahrzeugs oder dergleichen, wobei das Störsignal mit wenigstens einer bekannten Störsignalfrequenz auftritt und das Verfahren gekennzeichnet ist durch: ein in einem ersten Schritt erfolgendes Ermitteln des Messsignals, ein in einem zweiten Schritt bezüglich der bekannten Störsignalfrequenz erfolgendes Vornehmen einer Fouriertransformation an dem Messsignal zur Ermittlung der Störsignalamplitude und der Störsignalphase, ein in einem dritten Schritt erfolgendes Ermitteln des Störsignals auf der Grundlage der Störsignalamplitude und der Störsignalphase, sowie ein in einem vierten Schritt erfolgendes Entfernen des Störsignals aus dem Messsignal zur Ermittlung des Nutzsignals.

Das Wesen der Erfindung besteht darin, dass die Fouriertransformation im zweiten Schritt nicht bezüglich einer Vielzahl von Frequenzen wie im Stand der Technik, sondern lediglich bezüglich der bekannten Störsignalfrequenz vorgenommen wird. Hierdurch wird der rechentechnische Aufwand zur Ermittlung des Nutzsignals aus dem Messsignal stark vermindert, so dass das Nutzsignal in Echtzeit vom Steuer- bzw. Regelgerät eines Fahrzeugs ermittelt werden kann.

Als Messsignale im Sinne der Erfindung kommen zahlreiche an Komponenten eines Fahrzeugs auftretende Messsignale in Frage, wobei bestimmte Kombinationen aus Messsignal und Störsignal für Fahrzeuge besonders typisch sind.

Bei einer ersten Ausführungsvariante des erfindungsgemäßen Verfahrens erfolgt das Ermitteln des Messsignals im ersten Schritt auf der Grundlage der Stell-Position einer Kupplung des Fahrzeugs, wobei Ursache des Störsignals eine Taumelschwingung der Antriebswelle des Fahrzeug-Antriebsmotors ist. Taumelschwingungen treten auf, wenn sich Unwuchten an der Welle des Antriebsmotors bilden. Die Unwuchten können prinzipbedingt und/oder durch nutzungsbedingten Verschleiß entstehen. Je länger ein Fahrzeug in Gebrauch ist, desto mehr nehmen Verschleiß und damit auch Unwuchten zu, was zu vermehrten Taumelschwingungen und entsprechenden Störsignalen führt. Das erfindungsgemäße Verfahren ist mithin bei länger in Gebrauch befindlichen Fahrzeugen besonders nutzbringend.

Bei einer zweiten Ausführungsvariante des erfindungsgemäßen Verfahrens erfolgt das Ermitteln des Messsignals im ersten Schritt auf der Grundlage der Stell-Position einer Kupplung des Fahrzeugs, wobei die Ursache des Störsignals eine Rupfschwingung der Kupplung ist. Rupfschwingungen an Kupplungen entstehen durch verunreinigte oder verzogene Komponenten der Kupplung. Auch Verunreinigungen und Verziehungen sind verschleißbedingt, weshalb wie bei der ersten Ausführungsvariante das erfindungsgemäße Verfahren bei länger in Gebrauch befindlichen Fahrzeugen besonders vorteilhaft nutzbar ist.

Störsignale werden häufig durch Eigenschwingungen bestimmter Komponenten eines Fahrzeugs verursacht. Da Frequenzen von Eigenschwingungen zumeist bestimmbar sind und mithin bekannte Störsignalfrequenzen im Sinne der Erfindung darstellen, ist das erfindungsgemäße Verfahren hier ebenfalls unmittelbar einsetzbar.

Als eigenschwingungsanfällige Komponente eines Fahrzeugs ist dessen Triebstrang als Gesamtheit betrachtet bekannt. Daher erfolgt bei einer dritten Ausführungsvariante des erfindungsgemäßen Verfahrens das Ermitteln des Messsignals im ersten Schritt auf der Grundlage der Eingangsdrehzahl des Getriebes des Fahrzeugs, wobei die Ursache des Störsignals eine Triebstrangeigenschwingung ist. Bei einer vierten Ausführungsvariante erfolgt das Ermitteln des Messsignals im ersten Schritt auf der Grundlage der Drehzahl der Antriebsräder des Fahrzeugs, wobei die Ursache des Störsignals eine Triebstrangeigenschwingung ist. Auf welcher Grundlage bei den letztgenannten beiden Ausführungsvarianten das Messsignal ermittelt wird, hängt von den jeweiligen technischen Gegebenheiten ab. Dabei ist zu berücksichtigen, dass die Raddrehzahl im Vergleich zur Getriebeeingangsdrehzahl bekanntlich deutlich geringer ist und daher eine schlechtere zeitliche Auflösung ermöglicht. Insofern wird, wenn vorhanden, das Drehzahlsignal der Getriebeausgangswelle gegenüber einem vorhandenen Raddrehzahlsignal zu bevorzugen sein.

Für das im vierten Schritt erfolgende Entfernen des Störsignals aus dem Messsignal gibt es mehrere Möglichkeiten. Gemäß einer fünften Ausführungsvariante des erfindungsgemäßen Verfahrens besteht das genannte Entfernen in einem Subtrahieren des Störsignals von dem Messsignal. Diese Möglichkeit ist rechentechnisch besonders einfach und kommt immer dann zum Zuge, wenn sich das Nutzsignal und das Störsignal zum Messsignal summieren.

In einer weiteren Ausführungsvariante stellt das Nutzsignal ein Schwingungssignal dar, beispielsweise ein Schwingungssignal in einem Antriebsstrang eines Kraftfahrzeugs. Somit setzt sich das Messsignal hier aus einem Schwingungssignal und einem diesem Schwingungssignal überlagerten Störsignal mit bekannter Störfrequenz zusammen. Nach dem Entfernen des Störsignals aus dem Messsignal kann das hier als Schwingungssignal vorliegende Nutzsignal in entsprechenden Steuer- und/oder Regelalgorithmen verwendet werden.

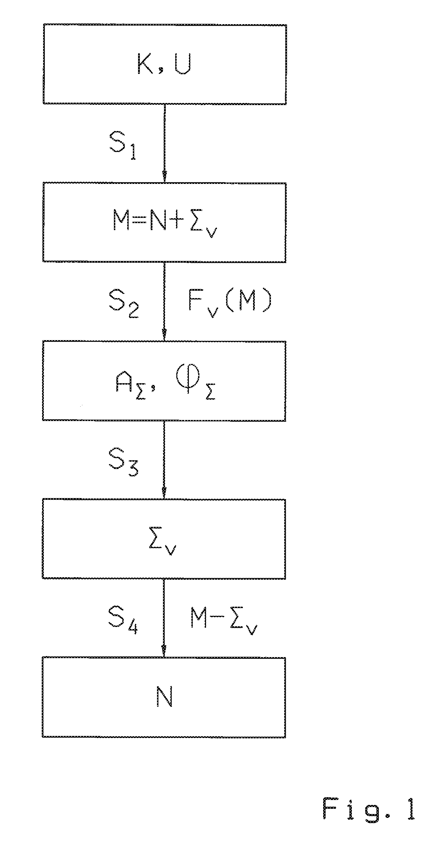

Das erfindungsgemäße Verfahren wird im Folgenden anhand der beiliegenden Zeichnung allgemein erläutert. In der Zeichnung zeigt Fig. 1 ein schematisches Flussdiagramm zur Erläuterung des erfindungsgemäßen Verfahrens.

Wie in Fig.1 gezeigt ist, bilden den Ausgangspunkt des erfindungsgemäßen Verfahrens eine betriebsspezifische Kenngröße K einer Fahrzeugkomponente und eine Ursache U einer Störung mit bekannter Periode. Bei Fahrzeugen sind bestimmte Kombinationen aus der Kenngröße K und der Ursache U besonders typisch. Beispiele für eine derartige Kombination sind die Stell-Position der Anfahr-Kupplung des Fahrzeugs als Kenngröße K und eine Taumelschwingung der Antriebswelle des Fahrzeug-Antriebsmotors als Ursache U der Störung, die Stell-Position der Anfahr-Kupplung des Fahrzeuges als Kenngröße K und eine Rupfschwingung der Kupplung als Ursache U der Störung, die mittlere Eingangsdrehzahl des Getriebes des Fahrzeugs als Kenngröße K und eine Triebstrangeigenschwingung als Ursache U der Störung oder die Drehzahl der Räder des Fahrzeugs als Kenngröße K und eine Triebstrangeigenschwingung als Ursache U. Andere einem Fachmann auf dem Gebiet der Fahrzeugtechnik geläufige Kombinationen sind ebenfalls möglich.

In einem ersten Schritt S₁ wird mittels geeigneter Sensoren aus der Kenngröße K und der Ursache U der periodischen Störung ein elektrisches Messsignal M ermittelt. Das Messsignal M stellt eine Überlagerung zweier Signale dar, nämlich eines Nutzsignals N und eines Störsignals Σᵥ. Das Nutzsignal N leitet sich hierbei aus der Kenngröße K ab, während das Störsignal Σᵥ als Folge einer Störung entsteht. Da die Störung periodisch ist, tritt das Störsignal Σᵥ mit einer Störsignalfrequenz v auf. Die Überlagerung des Nutzsignals N und des Störsignals Σᵥ zum Messsignal M stellt sich im einfachsten Fall als die Summe aus dem Nutzsignal N und dem Störsignal Σᵥ dar.

Die Ermittlung des Messsignals erfolgt mittels einem Fachmann auf dem Gebiet der Fahrzeugtechnik bekannter Verfahren und Vorrichtungen, so beispielsweise mittels Sensoren, die Drehzahlen, Stell-Positionen einer Kupplung, Geschwindigkeiten des Fahrzeugs oder andere Kenngrößen ermitteln und in verwertbarer Form, beispielsweise in Form einer elektrischen Spannung, bereitstellen.

In einem zweiten Schritt S₂ wird an dem Messsignal M bezüglich der bekannten Störsignalfrequenz v eine Fouriertransformation Fᵥ(M) vorgenommen. Durch die Fouriertransformation Fᵥ(M) werden die Störsignalamplitude A_{Σ} und die Störsignalphase ϕ_{Σ} des Störsignals Σᵥ ermittelt. Das Vornehmen der Fouriertransformation Fᵥ(M) erfolgt in einem Steuer- bzw. Regelgerät des Fahrzeugs, üblicherweise in Form eines Computer-Programms.

In einem dritten Schritt S₃ wird das Störsignal Σᵥ auf Grundlage der Störsignalamplitude A_{Σ} und der Störsignalphase ϕ_{Σ} ermittelt. Auch das Ermitteln des Störsignals Σᵥ auf Grundlage der Störsignalamplitude A_{Σ} und der Störsignalphase ϕ_{Σ} wird im Steuer- bzw. Regelgerät des Fahrzeugs vorgenommen.

Sowohl das in dem zweiten Schritt S₂ erfolgende Vornehmen der Fouriertransformation Fᵥ(M) wie auch das in dem dritten Schritt S₃ erfolgende Ermitteln des Störsignals Σᵥ sind einem Fachmann auf dem Gebiet der Fahrzeugtechnik bekannt und werden daher hier nicht näher erläutert.

In einem vierten Schritt S₄ wird schließlich das Störsignal Σᵥ aus dem Messsignal M entfernt, um das Nutzsignal N zu ermitteln. Da das Messsignal M eine Summe aus dem Nutzsignal N und dem Störsignal Σᵥ ist, besteht das Entfernen des Störsignals Σᵥ aus dem Messsignal M im vorliegenden Fall in einem Subtrahieren des Störsignals Σᵥ von dem Messsignal M. Auch das in dem vierten Schritt S₄ erfolgende Subtrahieren wird in dem Steuer- bzw. Regelgerät des Fahrzeugs vorgenommen.

Das mittels des erfindungsgemäßen Verfahrens ermittelte Nutzsignal N kann dann zur Analyse der dem Nutzsignal N zugrunde liegenden Kenngröße K und im Gefolge dessen zu deren Steuerung oder Regelung verwendet werden.

Die vorstehende Beschreibung stellt darauf ab, dass dem Messsignal M ein Störsignal Σᵥ mit bekannter Störsignalfrequenz v überlagert ist. Es ist einsichtig, dass dem Messsignal M auch mehrere Störsignale Σᵥ überlagert sein können, die jeweils mit einer eigenen Störsignalfrequenz v auftreten. In diesem Fall werden der zweite Schritt S₂, der dritte Schritt S₃ und der vierte Schritt S₄ des erfindungsgemäßen Verfahrens jeweils für jede Störsignalfrequenz v separat vorgenommen.

Die Verwendung des erfindungsgemäßen Verfahrens ist nicht auf die Fahrzeugtechnik beschränkt. Das erfindungsgemäße Verfahren ist vielmehr auf allen Gebieten der Technik anwendbar, auf denen einem Messsignal M wenigstens ein Störsignal Σᵥ überlagert ist.

Es wurde deutlich gemacht, dass die Fouriertransformation Fᵥ(M) im zweiten Schritt S₂ des erfindungsgemäßen Verfahrens lediglich bezüglich der bekannten Störsignalfrequenz v des Störsignals Σᵥ vorgenommen wird. Hierdurch wird der rechentechnische Aufwand bei der Ermittlung des Nutzsignals N aus dem Messsignal M gering gehalten, weshalb das Nutzsignal in Echtzeit vom Steuer- bzw. Regelgerät des Fahrzeugs ermittelt werden kann.

### Bezugszeichen

- K: Kenngröße
- M: Messsignal
- N: Nutzsignal
- U: Ursache einer Störung
- Σᵥ: Störsignal
- v: Störsignalfrequenz
- Fᵥ(M): Fouriertransformation an dem Messsignal
- A_{Σ}: Störsignalamplitude
- ϕ_{Σ}: Störsignalphase
- S₁: Erster Schritt
- S₂: Zweiter Schritt
- S₃: Dritter Schritt
- S₄: Vierter Schritt

## Patentansprüche

1. Verfahren zum Ermitteln eines Nutzsignals (N) aus einem von wenigstens einem Störsignal (Σᵥ) überlagerten Messsignal (M) zur Verwendung in einem Steuer- bzw. Regelgerät, beispielsweise eines Fahrzeugs oder dergleichen, wobei das Störsignal (Σᵥ) mit wenigstens einer bekannten Störsignalfrequenz (v) auftritt,
**gekennzeichnet durch**
- ein in einem ersten Schritt (S₁) erfolgendes Ermitteln des Messsignals (M),
- ein in einem zweiten Schritt (S₂) bezüglich der bekannten Störsignalfrequenz (v) erfolgendes Vornehmen einer Fouriertransformation (Fᵥ(M)) an dem Messsignal (M) zur Ermittlung der Störsignalamplitude (A_{Σ}) und der Störsignalphase (ϕ_{Σ}),
- ein in einem dritten Schritt (S₃) erfolgendes Ermitteln des Störsignals (Σᵥ) auf der Grundlage der Störsignalamplitude (A_{Σ}) und der Störsignalphase (ϕ_{Σ}), und
- ein in einem vierten Schritt (S₄) erfolgendes Entfernen des Störsignals (Σᵥ) aus dem Messsignal (M) zur Ermittlung des Nutzsignals (N).

2. Verfahren nach Anspruch 1, **dadurch gekennzeichnet, dass** das in dem ersten Schritt (S₁) erfolgende Ermitteln des Messsignals (M) auf der Grundlage der Stell-Position einer Kupplung des Fahrzeugs erfolgt und die Ursache (U) des Störsignals (Σᵥ) eine Taumelschwingung der Welle des Fahrzeug-Antriebsmotors ist.

3. Verfahren nach Anspruch 1, **dadurch gekennzeichnet, dass** das in dem ersten Schritt (S₁) erfolgende Ermitteln des Messsignals (M) auf der Grundlage der Stell-Position einer Kupplung des Fahrzeugs erfolgt und die Ursache (U) des Störsignals (Σᵥ) eine Rupfschwingung der Kupplung ist.

4. Verfahren nach Anspruch 1, **dadurch gekennzeichnet, dass** das in dem ersten Schritt (S₁) erfolgende Ermitteln des Messsignals (M) auf der Grundlage der Eingangsdrehzahl des Getriebes des Fahrzeugs erfolgt und die Ursache (U) des Störsignals (Σᵥ) eine Triebstrangeigenschwingung ist.

5. Verfahren nach Anspruch 1, **dadurch gekennzeichnet, dass** das in dem ersten Schritt (S₁) erfolgende Ermitteln des Messsignals (M) auf der Grundlage der Drehzahl der Räder des Fahrzeugs erfolgt und die Ursache (U) des Störsignals (Σᵥ) eine Triebstrangeigenschwingung ist.

6. Verfahren nach einem der vorhergehenden Ansprüche, **dadurch gekennzeichnet, dass** das in dem vierten Schritt (S₄) erfolgende Entfernen des Störsignals (Σᵥ) aus dem Messsignal (M) durch Subtrahieren des Störsignals (Σᵥ) von dem Messsignal (M) erfolgt.
